# FASCICULE DE BREVET EUROPEEN

(11) **EP 2 339 616 B1**
(45) Date de publication et mention de la délivrance du brevet: **13.04.2022**
(21) Numéro de dépôt: 10354093.6
(22) Date de dépôt: 20.12.2010
(51) Int. Cl.: H01L 21/762

(54) **Procédé de réalisation simplifié d'un substrat hybride**
Vereinfachtes Herstellungsverfahren eines Hybridsubstrats
Method for simplified production of a hybrid substrate

(30) Priorité: 22.12.2009 FR 0906233
(43) Date de publication de la demande: 29.06.2011
(73) Titulaire: Commissariat à l'Énergie Atomique et aux Énergies Alternatives, 75015 Paris (FR); STMicroelectronics Crolles 2 SAS, 38920 Crolles (FR)
(72) Inventeur: Fenouillet-Béranger, Claire, 38400 Saint Martin d'Hères (FR); Denorme, Stéphane, 38920 Crolles (FR); Coronel, Philippe, 38530 Barraux (FR)
(74) Mandataire: Talbot, Alexandre

(56) Documents cités:
- JP-A- 2006 229 047
- JP-A- 2007 042 915
- US-A1- 2004 256 700
- US-A1- 2005 116 290
- US-A1- 2005 236 687
- US-A1- 2006 024 931

## Description

### Domaine technique de l'invention

L'invention est relative à un procédé de réalisation d'un substrat hybride.

L'invention est également relative à un substrat hybride comportant :
- une première zone active en premier matériau semi-conducteur,
- une seconde zone active en second matériau semi-conducteur,
- les première et seconde zones actives étant disposées, latéralement, de part et d'autre d'une zone d'isolation en premier matériau d'isolation,
- les premier et second matériaux semi-conducteurs étant séparés par une couche d'isolation en second matériau d'isolation dans une direction perpendiculaire à une surface principale d'une couche de support.

### État de la technique

L'utilisation de transistors à effet de champ formés sur des substrats de type silicium sur isolant présente de nombreux avantages, notamment, une simplification du dessin des circuits intégrés et une amélioration des performances des dispositifs. De plus, afin de satisfaire à des contraintes toujours plus importantes, les substrats utilisés présentent des épaisseurs de silicium et d'oxyde enterré de plus en plus fines.

Cependant, l'utilisation d'un transistor intégré sur un film mince présente également de nombreux inconvénients. Les dispositifs à effet de champ sont, par exemple, inadaptés à l'utilisation de courants importants que l'on retrouve typiquement dans les modules d'entrée/sortie. Il est également difficile d'intégrer un transistor bipolaire sur un substrat de type semi-conducteur sur isolant mince ce qui limite les possibilités offertes quant aux dispositifs utilisables dans les circuits intégrés.

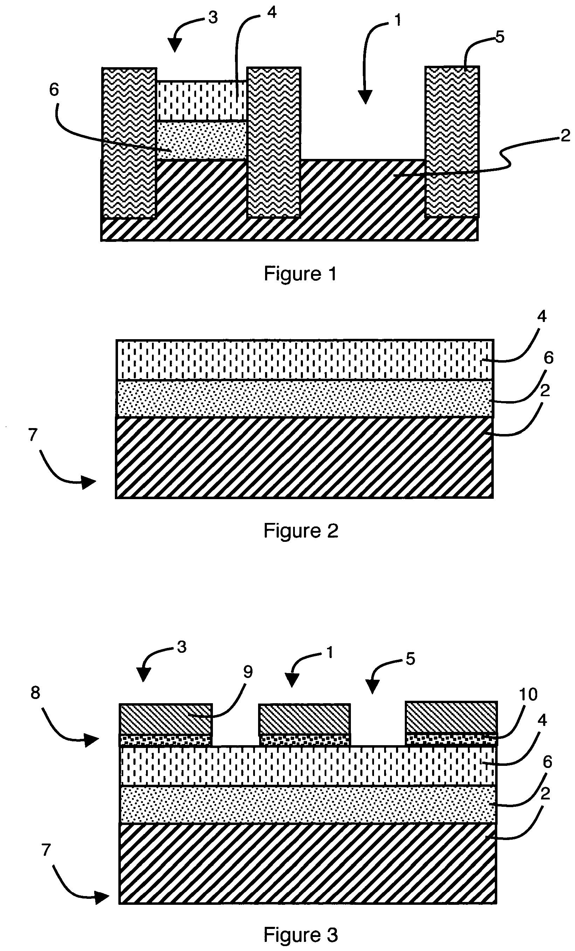

Afin de s'autoriser une plus grande largesse dans la conception des circuits intégrés, des substrats hybrides sont utilisés. Comme illustré à la figure 1, ces substrats hybrides comportent une première zone active 1 en premier matériau semi-conducteur 2, typiquement une zone de semi-conducteur sur isolant et une seconde zone active 3 en second matériau semi-conducteur 4 qui est de type substrat massif. Les première 1 et seconde 3 zones actives sont séparées latéralement par une zone d'isolation 5.

Comme illustré à la figure 2, ces substrats hybrides sont réalisés à partir d'un substrat souche de type semi-conducteur sur isolant qui est transformé afin de présenter les deux types de zones actives 1, 3. Le substrat souche comporte une couche d'isolation 6 qui est disposée entre les premier et second matériaux semi-conducteur. Ces deux types de zones actives sont alors utilisées pour former des dispositifs différents. Une manière conventionnelle de réaliser un tel substrat hybride est de graver le second matériau semi-conducteur 4 et la couche d'isolation 6 pour atteindre le premier matériau semi-conducteur 2, une fois que les zones d'isolation sont réalisées. Ainsi, le substrat de silicium est mis à nu et forme la première zone active 1. La zone d'isolation 5 s'enfonce dans le substrat en silicium 2 et est plus haute que la couche de silicium sur isolant de la seconde zone active 3. La première zone active 1 est donc encaissée entre les différentes zones d'isolation 5.

Afin de ne libérer que les zones actives choisies, le procédé de réalisation d'un substrat hybride est compliqué à mettre en œuvre. Il nécessite l'alignement d'une étape de photolithographie et de gravure par rapport aux différentes zones actives présente. Un désalignement de l'étape de protection des secondes actives 3 entraîne l'obtention de motifs parasites dans la première 1 et/ou la seconde 3 zones actives et une élimination au moins partielle d'un des motifs d'isolation 5 bordant les première 1 et/ou seconde 3 zones actives. Il apparaît donc que le procédé de réalisation limite fortement les possibilités d'intégration de la structure d'un point de vue industriel.

Le substrat obtenu n'est pas non plus optimal car il est moins pratique à utiliser que les substrats conventionnels et les circuits obtenus n'ont pas une durée de vie et un rendement de fabrication aussi bon que les circuits réalisés sur les substrats conventionnels.

Les documents JP 2007 042915 A et JP 2006 229047 A se rapportent à la fabrication des substrats à deux zones actives qui ont des propriétés différentes.

### Objet de l'invention

L'invention a pour objet un procédé de réalisation d'un substrat hybride qui soit facile à mettre en œuvre et qui utilise un nombre limité de niveaux photolithographiques, afin d'être robuste vis-à-vis des aléas liés aux équipements utilisés.

Le procédé selon l'invention est caractérisé par les revendications annexées et plus particulièrement par le fait qu'il comporte:
- prévoir un substrat comportant successivement une couche de support, une couche en premier matériau semi-conducteur, une couche d'isolation en second matériau d'isolation et une couche en second matériau semi-conducteur,
- la formation d'un masque de gravure destiné à délimiter la zone d'isolation, la première zone active et la seconde zone active, les première et seconde zones actives étant décalées latéralement et séparées par la zone d'isolation,
- graver les couches en premier et second matériaux semi-conducteurs et la couche d'isolation pour délimiter au moins la zone d'isolation et la première zone active dans le premier matériau semi-conducteur, libérer une surface principale de la première zone active formant ainsi des zones vides dans le substrat souche, le masque de gravure étant éliminé au-dessus de la première zone active, la première zone active étant formée dans le premier matériau semi-conducteur et la seconde zone active étant formée dans le second matériau semi-conducteur,
- le remplissage des zones vides et du masque de gravure, par le premier matériau d'isolation,
- la gravure du premier matériau d'isolation jusqu'à libérer la surface principale de la première zone active et former la zone d'isolation en premier matériau d'isolation.

Le substrat selon l'invention est caractérisé en ce que la zone d'isolation comporte une première portion bordant au moins un bord latéral de la première zone active, la première portion et la première zone active ayant une face principale libre formant un même plan avec l'interface entre la couche en premier matériau semi-conducteur et la couche d'isolation, la zone d'isolation et la première zone active ayant des formes complémentaires le long d'une interface entre la zone d'isolation et la première zone active.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, en coupe, un substrat hybride selon l'art antérieur,
- la figure 2 représente, de manière schématique, en coupe, un substrat selon l'art antérieur,
- les figures 3, 4, 5, 19 et 20 représentent, de manière schématique, en coupe et en vue de dessus, les étapes d'un procédé de réalisation d'un substrat hybride, selon l'invention,
- les figures 6 à 10 représentent de manière schématique, en coupe, différentes variantes d'un premier mode de réalisation du procédé selon l'invention,
- les figures 11 à 18 représentent de manière schématique, en coupe, différentes variantes d'un second mode de réalisation du procédé selon l'invention.

### Description d'un mode de réalisation préférentiel de l'invention

Comme illustré à la figure 2, le substrat de départ est un substrat souche qui comporte au moins une couche en premier matériau semi-conducteur 2, une couche en second matériau semi-conducteur 4 et une couche d'isolation 6. Le substrat souche comporte également une couche de support 7.

La couche en premier matériau semi-conducteur 2 peut être formée à la surface de la couche dé support 7 ou être formée par une zone surfacique de la couche de support 7, c'est-à-dire dans la couche de support 7 (figure 2). La couche en premier matériau semi-conducteur 2 peut également être de type semi-conducteur sur isolant, par exemple de type partiellement déplété. Elle est alors séparée de la couche de support 7 par un matériau diélectrique dit diélectrique enterré (non représenté). De ce fait, le premier matériau semi-conducteur 2 peut être dans le même matériau que la couche de support 7 ou alors dans un matériau différent. Il est également envisageable que la couche de support 7 et le premier matériau semi-conducteur 2 présentent la même orientation cristallographique ou des orientations différentes.

La couche en second matériau semi-conducteur 4 est séparée de la couche en premier matériau semi-conducteur 2 par au moins une couche d'isolation 6. Le second matériau semi-conducteur 4 est donc de type semi-conducteur sur isolant. Le second matériau semi-conducteur 4 est séparé de la couche de support 7 au moins par la couche d'isolation 6 si le premier matériau semi-conducteur 2 est réalisé directement à la surface de la couche de support 7. Les premier 2 et second 4 matériaux semi-conducteurs peuvent être dans des matériaux identiques ou différents et présenter des orientations identiques ou différentes.

Ainsi, dans une vue en coupe et quel que soit l'empilement utilisé, le substrat souche comporte au moins successivement la couche de support 7, la couche en premier matériau semi-conducteur 2, la couche d'isolation 6 et la couche en second matériau semi-conducteur 4. Le substrat souche peut également comporter des couches additionnelles en matériaux semi-conducteurs et des couches d'isolation additionnelles. Cependant, quel que soit le mode de réalisation, la couche en premier matériau semi-conducteur 2 est disposée entre la couche de support 7 et la couche d'isolation 6. De même, la couche d'isolation 6 est disposée entre les premier 2 et second 4 matériaux semi-conducteurs. Le substrat source peut donc être de type semi-conducteur sur isolant.

Le substrat hybride devant être utilisé pour réaliser des circuits intégrés, il est avantageux de limiter au maximum la différence de hauteur entre la surface principale de la première zone active 1 en premier matériau semi-conducteur 2 et la surface principale de la seconde zone active 3 en second matériau semi-conducteur 4. La surface principale des zones actives est la surface sur laquelle est formée un transistor ou un dispositif électronique en général. Plus cette différence de hauteur est importante et plus il est difficile de réaliser des étapes de photolithographies de bonne qualité à cause des limitations de profondeur de champ des équipements utilisés.

Comme illustré à la figure 3, un masque de gravure 8 est formé sur le substrat souche, c'est-à-dire sur la couche la plus éloignée de la couche de support 7, ici le second matériau semi-conducteur 4. A titre d'exemple, le masque de gravure est formé dans un masque dur en premier matériau de protection 9. Dans une variante de réalisation, le masque de gravure 8 comporte au moins un premier matériau de protection 9 qui recouvre un matériau de protection additionnel 10. Selon les modes de réalisation le premier matériau de protection 9 et le matériau de protection additionnel 10 peuvent présenter des structurations différentes et donc des dessins différents.

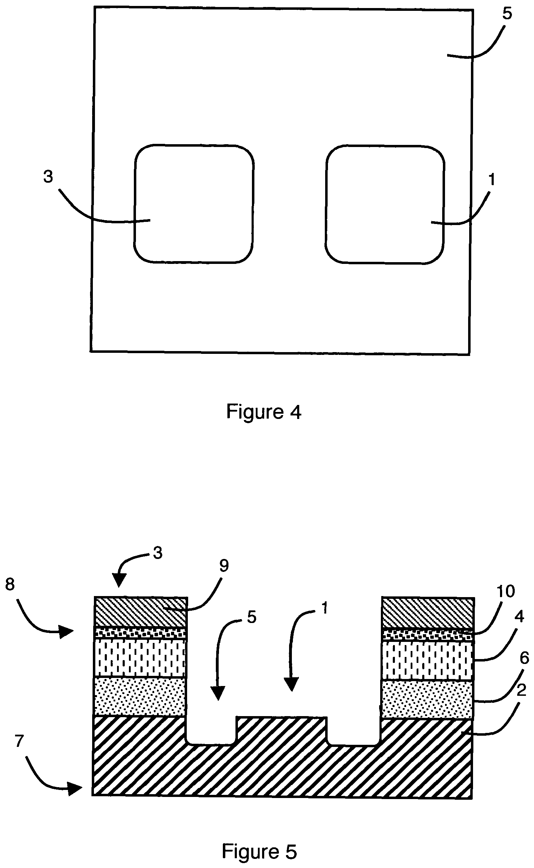

Le masque dur est structuré afin de former le masque de gravure 8. Le masque de gravure 8 délimite au moins une première zone active 1 du substrat, une seconde zone active 3 du substrat et une zone d'isolation 5 du substrat. Le masque de gravure peut délimiter une pluralité de premières zones actives 1, de secondes zones actives 3 et de zones d'isolation 5. Les première 1 et seconde 3 zones actives et la zone d'isolation 5 étant formées dans le masque de gravure, elles sont obligatoirement décalées latéralement les unes par rapport aux autres. Une zone d'isolation 5 sépare les première 1 et seconde 3 zones actives. En d'autres termes, dans un circuit intégré, la première zone active 1 et la seconde zone active 3 sont entourées par une zone d'isolation 5 comme illustré en vue de dessus à la figure 4. Dans le masque de gravure 8, la délimitation de la zone d'isolation 5 est définie par une zone vide alors que la délimitation des première 1 et seconde 3 zones actives est réalisée par une zone pleine. Cependant, il est envisageable de réalisée un masque de gravure de polarité inverse et de modifier cette polarité au fur et à mesure des étapes du procédé.

Le masque de gravure 8 comporte donc des dessins distincts délimitant les premières zones actives 1, des dessins délimitant les secondes zones actives 3 et des dessins délimitant les zones d'isolation 5. Ces trois types de dessins représentent l'intégralité de la surface du masque de gravure 5 (figure 4).

Comme illustré à la figure 5, une fois le masque de gravure 8 réalisé, la couche en premier matériau semi-conducteur 2, la couche en second matériau semi-conducteur 4 et la couche d'isolation 6 sont structurées pour délimiter la zone d'isolation 5 dans le premier matériau semi-conducteur 2 et libérer la surface principale de la première zone active 1 en premier matériau semi-conducteur 2. La surface principale de la première zone active 1 devant être libérée, il est nécessaire d'éliminer au dessus du premier matériau semi-conducteur 2, la couche d'isolation 6, le second matériau semi-conducteur 4 et le masque de gravure 8 dans la zone indiquée. La structuration du premier matériau semi-conducteur 2 délimite simultanément la première zone active 1 et la zone d'isolation 5. La surface principale de la première zone active correspond à la surface du substrat de support qui réalisait l'interface avec la couche d'isolation. De cette manière, la surface principale de la première zone active est sous le niveau de la couche d'isolation 6. La surface principale de la première zone active est ici dans le même plan que l'interface entre le premier matériau semi-conducteur et la couche d'isolation 6.

Lors de cette structuration, la première zone active 1, la zone d'isolation 5 et la seconde zone active 3 sont délimitées. Il y a également structuration du masque de gravure 8 pour éliminer la portion du masque de gravure 8 qui délimite la première zone active 1. Cependant, cette structuration du masque de gravure 8 peut intervenir à différents moments selon les modes de réalisation utilisés.

De manière classique, pour atteindre le premier matériau semi-conducteur 2, la couche en second matériau semi-conducteur 4 et la couche d'isolation 6 sont structurées. Cette structuration peut être réalisée classiquement au moyen d'une gravure par plasma et elle peut s'enfoncer après le premier matériau semi-conducteur 2, par exemple jusque dans la couche de support 7.

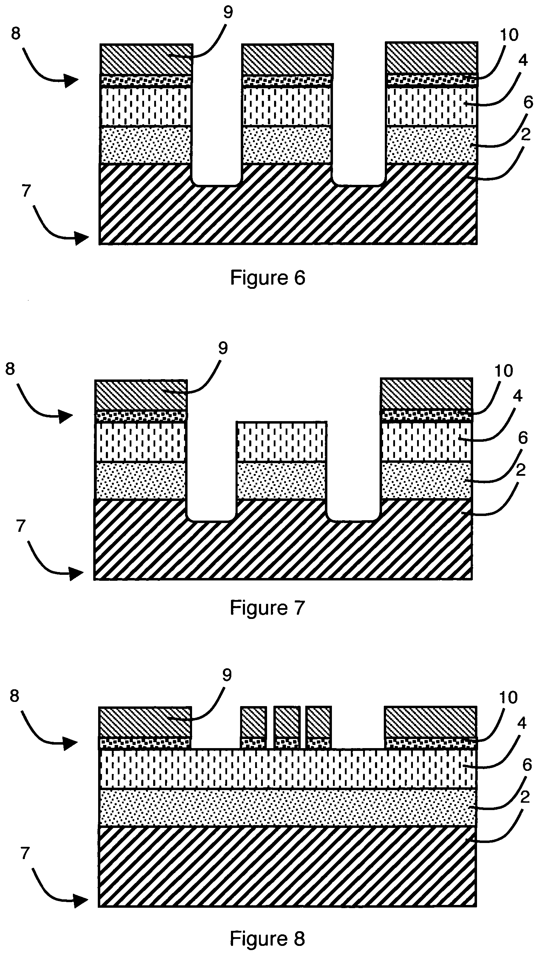

Dans un premier mode de réalisation, illustré à la figure 6, la zone libre du masque de gravure 8 délimite la zone d'isolation 5. Le second matériau semi-conducteur 4, la couche d'isolation 6 puis le premier matériau semi-conducteur 2 sont structurés successivement à partir du dessin représenté par la zone libre du masque de gravure 8. Le dessin de la zone d'isolation 5 est donc gravé dans les différentes couches se situant entre le masque de gravure 8 et la couche en premier matériau semi-conducteur 2. Cette structuration forme une zone vide dans le second matériau semi-conducteur 4, la couche d'isolation 6 et le premier matériau semi-conducteur 2. Cette structuration délimite également la seconde zone active 3 en second matériau semi-conducteur 4 au moment de la gravure de ce second matériau semi-conducteur 4.

Comme illustré à la figure 7, le masque de gravure 8 est ensuite structuré pour être éliminé au niveau de la première zone active 1. L'élimination de la portion du masque de gravure 8 qui délimite la première zone active 1 peut être réalisée par toute technique adaptée, par exemple au moyen d'une étape de photolithographie et de gravure. La surface principale de la première zone active est ensuite libérée en éliminant le second matériau semi-conducteur 4 et la couche d'isolation 6 se trouvant juste au dessus de la première zone active. Le masque de gravure 8 peut être avantageusement utilisé pour protéger le reste du substrat lors de la gravure.

Dans une variante de réalisation avantageuse, illustrée à la figure 8, le dessin délimitant la première zone active 1 dans le masque de gravure 8 est réalisé au moyen d'une pluralité de motifs espacés les uns des autres. Ainsi, dans le masque de gravure 8, la délimitation de la première zone active 1 est réalisée par une alternance de motifs et de zones vides. La distance entre deux bords latéraux en regard de deux motifs adjacents est inférieure à la plus petite distance qui existe entre un bord latéral d'un dessin délimitant la première zone active 1 et un bord latéral d'un dessin délimitant la seconde zone active 3. En d'autres termes, la plus grande distance entre deux motifs adjacents est inférieure à la plus petite distance qui sépare la paroi latérale du dessin délimitant la première zone active de la paroi latérale du dessin de la seconde zone active 3. De plus, la dimension latérale et/ou longitudinale des motifs est inférieure à l'épaisseur du masque de gravure. A titre d'exemple, les motifs sont espacés d'environ le tiers de la distance qui sépare normalement deux transistors. Dans une intégration pour le nœud technologique 45nm, la distance minimale qui sépare deux transistors est de l'ordre de 100nm et de ce fait, la distance qui sépare deux motifs est de l'ordre de 30nm. Pour une intégration dans des nœuds technologiques inférieurs, il suffit de diminuer les distances précisées plus haut.

De ce fait, les motifs peuvent être de forme quelconque, par exemple, ils peuvent être carrés ou rectangulaires ou les deux. La paroi latérale du dessin délimitant la première zone active est obtenue en reliant tous les motifs se situant sur les bords. Leur taille peut être quelconque tant que la distance entre les motifs est respectée.

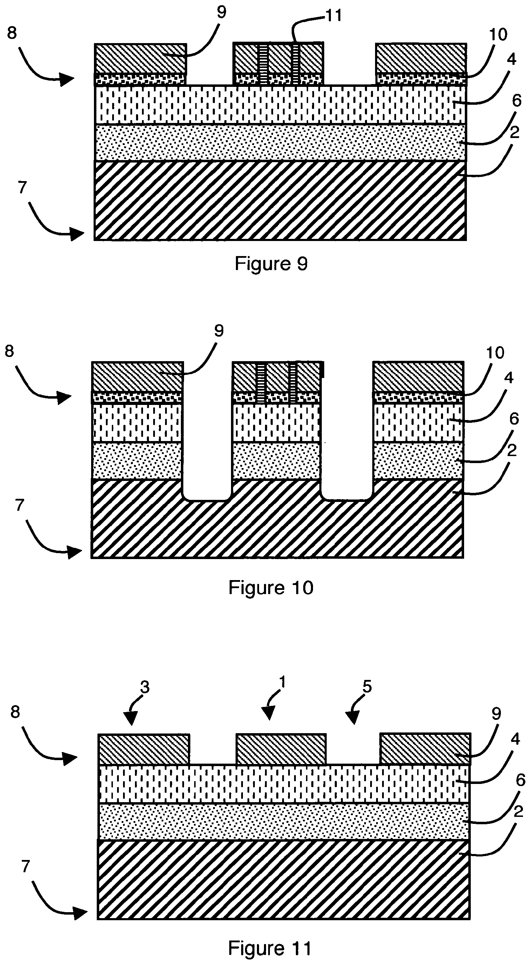

Comme illustré à la figure 9, un premier bouchon 11 est formé dans les espaces entre les motifs du dessin délimitant la première zone active afin de former un dessin plein, c'est-à-dire sans zone vide. Avantageusement, le premier bouchon 11 est formé au moyen d'un matériau de recouvrement déposé de manière conforme, c'est-à-dire qui épouse la forme du matériau qu'il recouvre. L'espace entre les motifs étant plus petit que l'espace entre la première zone active 1 et la seconde zone active 3, le matériau de recouvrement rebouche les zones vides du dessin de la première zone active 1 sans complètement reboucher le dessin délimitant la zone d'isolation, également une zone vide. L'épaisseur du matériau de recouvrement est choisie en conséquence et le matériau de recouvrement est ensuite éliminé de manière isotrope. De cette manière, le matériau de recouvrement n'est présent que dans le dessin délimitant la première zone active 1. La zone vide du masque de gravure 8 ne délimite plus que la zone d'isolation 5.

La structuration du second matériau semi-conducteur 4, de la couche d'isolation 6 et du premier matériau semi-conducteur 2 peut ensuite être réalisée. Une fois la structuration effectuée, le matériau de recouvrement est éliminé sélectivement par tout procédé adapté et les motifs délimitant la première zone active 1 sont éliminés. Cette élimination est avantageusement réalisée au moyen d'une gravure isotrope du ou des matériaux constituant le masque de gravure 8. Il y a alors un léger retrait du masque de gravure 8 au niveau des parois latérales des dessins des première 1 et seconde 3 zones actives.

Dans le cas où le masque de gravure 8 au dessus de la première zone active 1 comporte un matériau de protection additionnel 10, l'élimination des motifs du dessin délimitant la première zone active 1 est réalisée au moyen de la gravure sélective du matériau de protection additionnel 10. Cette gravure sélective entraîne un décollement des motifs. Il est envisageable que le matériau de recouvrement et le matériau de protection additionnel 10 soit les mêmes ou qu'ils présentent une réactivité au même procédé de gravure.

Comme illustré à la figure 10, une fois le dessin du masque de gravure 8 délimitant la première zone active 1 éliminé, les parties du second matériau semi-conducteur 2 et de la couche d'isolation 6 délimitant la première zone active 1 sont également éliminées. Ainsi, une fois la zone d'isolation 5 définie dans le premier matériau semi-conducteur 2, tous les matériaux qui se trouvent au dessus de la première zone active 1 en premier matériau semi-conducteur 2 sont enlevés, y compris le masque de gravure 8 pour libérer la surface principale de la première zone active 1.

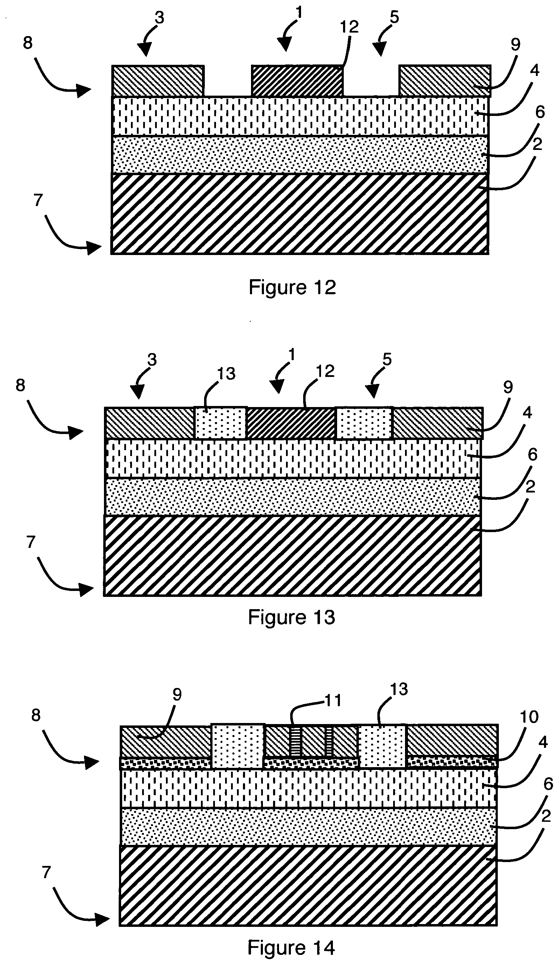

Dans une variante de réalisation illustrée aux figures 11 et 12, le premier matériau de protection 9 est remplacé par un second matériau de protection 12 uniquement dans le dessin délimitant la première zone active 1. Ce second matériau de protection 12 présente une sélectivité de gravure par rapport au premier matériau de protection 9. Le second matériau de protection 12 peut être formé par toute technique adaptée, par exemple, par l'implantation d'un dopant ou d'un autre matériau dans le premier matériau de protection 9 au niveau de la zone à transformer.

Dans une autre variante de réalisation illustrée à la figure 13, un second bouchon 13 est formé dans le masque de gravure 8 au niveau du dessin délimitant la zone d'isolation 5. Le second bouchon 13 délimite alors la zone d'isolation dans le masque de gravure 8. Après élimination du premier matériau de protection au niveau du dessin délimitant la première zone active, le second matériau de protection 12 est formé dans la zone vide du masque de gravure 8.

Dans encore une autre variante de réalisation, le masque de gravure comporte le premier matériau de protection 9 formé sur le matériau de protection additionnel 10. Le second matériau de protection 12 est alors formé par le matériau de protection additionnel 10 après élimination du premier matériau de protection 9. Avantageusement, le second bouchon est utilisé afin d'éviter la gravure latérale des dessins délimitant les première 1 et seconde 3 zones actives.

Dans tous ces modes de réalisation, le masque de gravure 8 délimite alors la première zone active 1, la seconde zone active 3 et la zone d'isolation 5 au moyen de trois matériaux différents qui peuvent présenter entre eux des différences d'épaisseur.

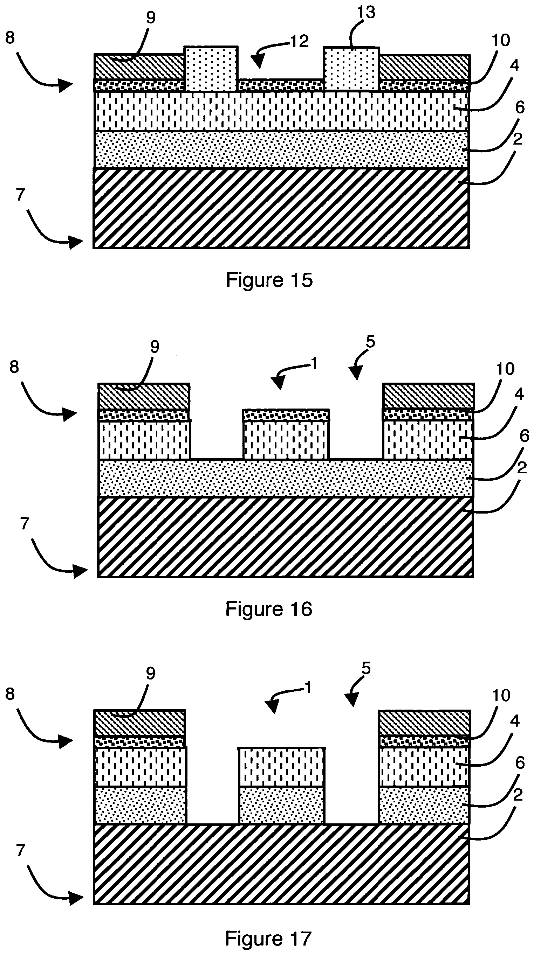

Comme dans un mode de réalisation précédent, le dessin du masque de gravure 8 délimitant la première zone active 1 peut être constitué par une pluralité de motifs espacés les uns des autres et qui présentent les mêmes contraintes dimensionnelles que précédemment. Le premier bouchon 11 est alors formé avant la formation du second matériau de protection 12. Dans une variante de réalisation avantageuse illustrée aux figures 14 et 15, le masque de gravure 8 comporte un premier matériau de protection 9 déposé au-dessus d'un matériau de protection additionnel 10. Le premier bouchon 11 est formé avant le second bouchon 13. La couche de protection additionnelle 10 est structurée une fois que le premier bouchon est formé. Le premier bouchon 11 est éliminé et le premier matériau de protection est éliminé au niveau du dessin de la première zone active au moyen d'une gravure anisotrope. De cette manière, l'épaisseur du premier matériau de protection 9 est légèrement diminuée dans le masque de gravure 8 et le dessin de la première zone active en premier matériau de protection 9 est éliminé (figure 15). Le second bouchon 13 est alors éliminé et le substrat est sensiblement identique à celui de la figure 12, l'épaisseur du masque de gravure 8 au dessus de la zone active étant plus faible.

Comme illustré à la figure 13, une fois le second matériau de protection formé, le second bouchon 13 est éliminé et la zone d'isolation 5 est structurée dans le premier matériau semi-conducteur. Les couches situées au-dessus de la première zone active en premier matériau semi-conducteur sont enlevés.

Dans un mode de réalisation avantageux illustré aux figures 16 à 18, le second matériau de protection 12 est dans le même matériau que la couche d'isolation 6 ou dans un matériau qui se grave avec le même procédé de gravure. De cette manière, le masque de gravure 8 en premier 9 et second 12 matériaux de protection est utilisé pour structurer le second matériau semi-conducteur 4 et délimiter la zone d'isolation 5 et la seconde zone active 3 dans le second matériau semi-conducteur 4. La couche d'isolation 6 est ensuite structurée pour délimiter la zone d'isolation 5. La couche d'isolation 6 et le second matériau de protection 12 étant réactifs au même procédé de gravure, le second matériau de protection 12 est éliminé au niveau de la première zone active 1. Le premier matériau semi-conducteur 2 est ensuite structuré pour délimiter la zone d'isolation 5 et donc la première zone active 1 au moyen du motif en couche d'isolation 6 délimitant la première zone active 1. Le motif en couche d'isolation 6 est ensuite éliminé.

Dans ce mode de réalisation, les structurations sont réalisées au moyen de gravures anisotropes qui reproduisent dans la couche inférieure le dessin de la première zone active 1 provenant du masque de gravure 8.

Dans tous ces modes de réalisation, la structuration de la couche d'isolation 6 et des couches en premier matériau semi-conducteur 2, en second matériau semi-conducteur 4 et la libération de la surface principale de la première zone active 1 forme des zones vides dans le substrat souche. Ces zones vides sont localisées dans le second matériau semi-conducteur 4, dans la couche d'isolation 6 et dans le premier matériau semi-conducteur 2. Les zones vides sont également présentent dans le masque de gravure 8.

Dans le masque de gravure 8, dans le second matériau semi-conducteur 4 et dans la couche d'isolation 6, les zones vides correspondent à la surface de la première zone active 1 et de la zone d'isolation 5. Dans le premier matériau semi-conducteur 1, la zone vide correspond uniquement à la zone d'isolation 5.

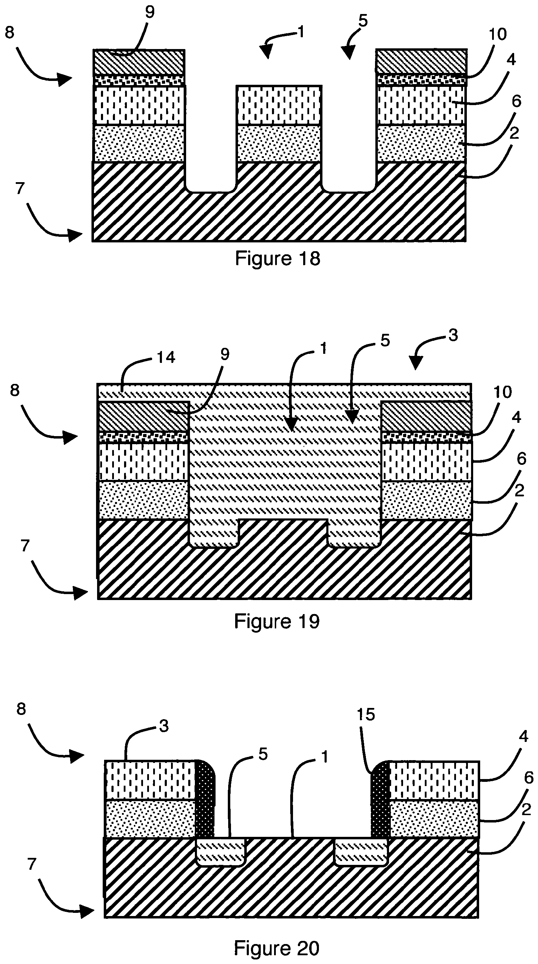

Comme illustré à la figure 19, dans tous les modes de réalisation, un premier matériau d'isolation 14 est déposé afin de remplir les zones vides du substrat souche et le masque de gravure 8. Ce premier matériau d'isolation 14 est un matériau isolant électriquement, par exemple de l'oxyde de silicium ou du nitrure de silicium. Le premier matériau d'isolation 14 peut être différent du second matériau d'isolation constituant la couche d'isolation 6. Les premier et second matériaux d'isolation peuvent également être identiques.

Le premier matériau d'isolation 14 rebouche la zone d'isolation formée dans le premier matériau semi-conducteur 2, mais également la zone vide représentative de la zone d'isolation 5 et de la première zone active 1 dans la couche d'isolation 6 et dans le second matériau semi-conducteur 4. Le premier matériau d'isolation 14 se dépose également sur le masque de gravure 8.

Le premier matériau d'isolation 14 subit de préférence une étape d'aplanissement, cette étape peut s'arrêter au-dessus ou au niveau du masque de gravure 8. Lors de cette opération, le masque de gravure peut être également gravé, mais il faut éviter de détériorer la surface principale du second matériau semi-conducteur 4. Une fois le premier matériau d'isolation 14 aplani, il subit une étape de gravure isotrope ou anisotrope afin de le localiser au niveau de la zone d'isolation 5 dans le premier matériau semi-conducteur 2. Dans cette étape de gravure, la planéité du premier matériau d'isolation est conservée tout au long de la gravure. Si la couche d'isolation 6 ou une autre des couches présentes et accessibles est réactive au procédé de gravure du premier matériau d'isolation 14, la gravure est réalisée au moyen d'un procédé anisotrope.

De cette manière, il est possible de positionner la surface supérieure du premier matériau d'isolation 14 où l'on veut par rapport à la surface principale de la première zone active 1 et/ou de la seconde zone active 2.

Dans un mode de réalisation avantageux illustré à la figure 20, la gravure du premier matériau d'isolation 14 est réalisée jusqu'à libérer la surface principale de la première zone active 1. Dans ce cas de figure, la surface principale de la première zone active 1 est exactement au même niveau que la surface principale de la zone d'isolation 5 en premier matériau d'isolation 14. La première zone active 1 et la zone d'isolation 5 ayant des formes complémentaires, aucune impureté ne peut se déposer à l'interface entre ces deux zones et les impuretés ne sont pas coincés sur la première zone active 1, par exemple à cause de zones d'isolation 5 qui sont plus hautes que la surface principale de la première zone active 1. De plus, le transistor formé sur la première zone active 1 ne présente pas de transistor parasite car la surface principale de la première zone active 1 n'est pas au dessus de la surface de la zone d'isolation 5.

Il est également possible, de volontairement rabaisser la surface principale de la zone d'isolation par rapport à celle de la première zone active 1. Dans ce cas, le premier matériau d'isolation 14 présentant une surface plane, cette surface plane est répercutée tout au long de la gravure, même en dessus de la surface principale de la première zone active 1, c'est-à-dire après la libération de la surface principale de la première zone active 1.

Dans une variante de réalisation illustrée à la figure 20, un espaceur latéral 15 est formé sur le bord latéral de la seconde zone active 3 en second matériau semi-conducteur 4, au dessus de la zone d'isolation 5 en premier matériau d'isolation 14. L'espaceur latéral 15 peut être formé après la localisation du premier matériau d'isolation 14 dans la zone d'isolation 5 du premier matériau semi-conducteur 2.

Un matériau isolant additionnel est déposé de manière conforme sur le substrat. Le matériau isolant additionnel recouvre le masque de gravure 8, la première zone active 1, le premier matériau d'isolation 14 et les parois latérales du masque de gravure 8, du second matériau semi-conducteur 4 et de la couche d'isolation 6. Le matériau isolant additionnel est ensuite gravé par plasma de manière anisotrope afin de ne localiser uniquement sur les parois latérales et ainsi former l'espaceur latéral 15.

L'espaceur latéral peut également être formé au cours de la gravure du premier matériau d'isolation 14. Le matériau isolant additionnel est déposé de manière conforme sur le substrat. Le matériau isolant additionnel recouvre le masque de gravure 8, le premier matériau d'isolation 14 et les parois latérales découvertes. Le matériau isolant additionnel est ensuite gravé par plasma de manière anisotrope afin de ne le localiser uniquement que sur les parois latérales. La gravure du premier matériau d'isolation 14 est alors reprise avec un procédé de gravure anisotrope et l'espaceur latéral est formé par le matériau isolant additionnel dans une partie supérieure et par le premier matériau d'isolation dans une partie inférieure.

L'épaisseur déposée du matériau isolant additionnel ainsi que l'épaisseur gravée dépendent de l'épaisseur choisie pour l'espaceur latéral.

Dans encore une autre variante de réalisation (non représentée), il est envisageable de ne libérer qu'une portion de la première zone active 1. Si l'espaceur latéral 15 est formé avant la libération de la surface principale de la première zone active 1 et si l'épaisseur de l'espaceur latéral 15 est supérieure à la distance séparant la première 1 et la seconde 3 zones actives (la largeur de la zone d'isolation 5), l'espaceur latéral 15 est disposé au dessus de la première zone active 1. Il est alors possible d'utiliser l'espaceur latéral 15 comme masque de gravure et de ne libérer qu'une partie de la première zone active 1. Ce mode de réalisation est particulièrement avantageux si on souhaite réaliser une élévation de la hauteur de la face principale de la première zone active 1, par exemple, par épitaxie sélective. Il est à noter que ce mode de réalisation est difficile à mettre en œuvre car il nécessite un certain nombre de contraintes géométriques pour obtenir un espaceur latéral 15 qui empiète sur la première zone active 1 (typiquement un masque de gravure très épais). L'ouverture dans le premier matériau d'isolation peut également être réalisée au moyen d'une étape de photolithographie additionnelle mais il y a alors perte de l'autoalignement de la première zone active 1 par rapport à la seconde zone active 3 et à la zone d'isolation 5.

Le masque de gravure 8 est ensuite éliminé, par toute technique adaptée, par exemple au moyen d'une gravure anisotrope telle qu'une gravure par voie humide et la surface principale de la seconde zone active est libérée.

Ce procédé de réalisation est particulièrement intéressant car il permet de manière autoalignée de former des première 1 et seconde 3 zones actives et une zone d'isolation 5. La position, la forme et les dimensions des différentes zones sont définies dès le masque de gravure 8.

Il est ainsi possible d'obtenir un substrat hybride qui comporte une première zone active 1 en premier matériau semi-conducteur 2, une seconde zone active 3 en second matériau semi-conducteur 4, les première 1 et seconde 2 zones actives étant disposées, latéralement, de part et d'autre d'une zone d'isolation 5 en premier matériau d'isolation 14. Les premier 2 et second 4 matériaux semi-conducteurs sont séparés par une couche d'isolation 6 en second matériau d'isolation dans une direction perpendiculaire à une surface principale d'une couche de support 7. Par ailleurs, la zone d'isolation 5 comporte une surface principale qui forme un plan unique avec la surface principale de la première zone active 1. La zone d'isolation 5 et la première zone active 1 ont des formes complémentaires le long de l'interface entre la zone d'isolation 5 et la première zone active 1. Les secondes zones actives 3 sont séparées électriquement des premières zones actives 1 par la couche d'isolation 6, d'un point de vue vertical.

Ce substrat hybride est particulièrement avantageux car il autorise la formation de dispositifs spécifiques sur des zones actives présentant des caractéristiques électroniques et/ou cristallograhiques prédéfinies. Les zones actives présentent une excellente qualité de surface car elles ont toujours été protégées des étapes agressives. Les surfaces principales des zones actives sont, en générale, libérées au moyen d'une gravure humide. Le substrat ne présente pas des topographies de surface à proximité immédiate des zones actives surtout au niveau de la première zone active. Ceci a pour effet de limiter les risques de contamination lié à un problème de nettoyage et de limiter les transistors parasites. Les topographies existantes sont déportées au-dessus des zones d'isolation ce qui limite l'effet de matériaux parasites sur le fonctionnement du dispositif.

## Revendications

1. Procédé de réalisation d'un substrat hybride comportant:
- prévoir un substrat comportant successivement une couche de support (7), une couche en premier matériau semi-conducteur (2), une couche d'isolation (6) en second matériau d'isolation et une couche en second matériau semi-conducteur (4),
- former un masque de gravure (8) comportant des dessins distincts délimitant respectivement une zone d'isolation (5), une première zone active (1) et une seconde zone active (3), les première (1) et seconde (3) zones actives étant décalées latéralement et séparées par la zone d'isolation (5), les dessins distincts représentant l'intégralité de la surface du masque de gravure (8), le dessin de la zone d'isolation (5) ayant une polarité opposée à la polarité des dessins de la première zone active (1) et de la seconde zone active (3),
- graver les couches en premier (2) et second (4) matériaux semi-conducteurs et la couche d'isolation (6) pour former une zone vide dans la couche en premier matériau semi-conducteur (2) et délimiter au moins la zone d'isolation (5) et la première zone active (1) dans la couche en premier matériau semi-conducteur (2), ladite gravure reproduisant dans les couches en premier (2) et second (4) matériaux semi-conducteurs et la couche d'isolation (6) les dessins provenant du masque de gravure (8),
- graver le masque de gravure (8), la couche d'isolation (6) et la couche en second matériau semi-conducteur (4) au-dessus de la première zone active (1) pour découvrir une surface principale de la première zone active (1), la première zone active (1) étant formée dans la couche en premier matériau semi-conducteur (2) et la seconde zone active (3) étant formée dans la couche en second matériau semi-conducteur (4),
- remplir les zones vides du substrat et du masque de gravure (8), par un premier matériau d'isolation (14),
- aplanir le premier matériau d'isolation (14),
- graver le premier matériau d'isolation (14) jusqu'à libérer la surface principale de la première zone active (1) et délimiter la zone d'isolation (5) en premier matériau d'isolation (14).

2. Procédé selon la revendication 1, **caractérisé en ce que** la libération de la surface principale de la première zone active (1) est réalisée après la gravure du premier matériau semi-conducteur (2) pour délimiter au moins la première zone active (1).

3. Procédé selon la revendication 1, **caractérisé en ce qu'**il comporte avant la gravure du premier matériau semi-conducteur (2), le remplacement d'un premier matériau de protection (9) du masque de gravure (8) par un second matériau de protection (12) au niveau du dessin de la première zone active (1), le second matériau de protection (12) étant réactif à un procédé de gravure de la couche d'isolation (6), le dessin de la seconde zone active (3) étant en premier matériau de protection (9).

4. Procédé selon la revendication 3, **caractérisé en ce que** le masque de gravure (8) comportant un premier matériau de protection (9) déposé sur un matériau de protection additionnel (10), un premier bouchon (11) est formé dans le masque de gravure (8) au niveau du dessin délimitant la zone d'isolation (5), le second matériau de protection (12) étant formé par le matériau de protection additionnel (10) après élimination du premier matériau de protection (9).

5. Procédé selon la revendication 4, **caractérisé en ce qu'**il comporte successivement l'élimination du premier bouchon (11), la structuration du second matériau semi-conducteur (4), la structuration de la couche d'isolation (6) et l'élimination simultanée du matériau de protection additionnel (10) délimitant la première zone active (1) et de la structuration de la couche d'isolation (6).

6. Procédé selon l'une quelconque des revendication 1 à 5, **caractérisé en ce que**, dans le masque de gravure (8), la délimitation de la première zone active (1) est réalisée par une alternance de motifs et de zones vides, la distance entre deux bords latéraux en regard de deux motifs adjacents est inférieure à la plus petite distance existant entre un bord latéral d'un dessin délimitant la première zone active (1) et un bord latéral d'un dessin délimitant la seconde zone active (3).

7. Procédé selon la revendication 6, **caractérisé en ce qu'**un second bouchon (13) est formé dans les zones vides entre les motifs délimitant la première zone active (1).

8. Procédé selon la revendication 7, **caractérisé en ce que** le second bouchon (13) est formé au moyen d'un matériau sacrificiel.

9. Procédé selon l'une quelconque des revendications 1 à 8, **caractérisé en ce que** la zone d'isolation (5) comporte un espaceur latéral (15) qui recouvre au moins la paroi latérale de la seconde zones active (3).

## Patentansprüche

1. Verfahren zur Herstellung eines Hybridsubstrats, umfassend:
- Bereitstellen eines Substrats, das aufeinanderfolgend eine Trägerschicht (7), eine Schicht aus einem ersten Halbleitermaterial (2), eine Isolierschicht (6) aus einem zweiten Isoliermaterial und eine Schicht aus einem zweiten Halbleitermaterial (4) umfasst,
- Bilden einer Ätzmaske (8), die einzelne Mustern umfasst, die jeweils einen Isolierbereich (5), einen ersten aktiven Bereich (1) und einen zweiten aktiven Bereich (3) abgrenzen, wobei der erste (1) und der zweite (3) aktive Bereich seitlich versetzt sind und durch den Isolierbereich (5) getrennt sind, die einzelnen Muster die Gesamtfläche der Ätzmaske (8) ausmachen, wobei das Muster des Isolierbereichs (5) eine Polarität aufweist, die der Polarität der Muster des ersten aktiven Bereichs (1) und des zweiten aktiven Bereichs (3) entgegengesetzt ist,
- Ätzen der Schichten aus dem ersten (2) und zweiten (4) Halbleitermaterial und der Isolierschicht (6), um in der Schicht aus dem ersten Halbleitermaterial (2) einen Leerbereich zu bilden und in der Schicht aus dem ersten Halbleitermaterial (2) mindestens den Isolierbereich (5) und den ersten aktiven Bereich (1) abzugrenzen, wobei das Ätzen die Muster von der Ätzmaske (8) in den Schichten aus dem ersten (2) und dem zweiten (4) Halbleitermaterial und in der Isolierschicht (6) reproduziert,
- Ätzen der Ätzmaske (8), der Isolierschicht (6) und der Schicht aus dem zweiten Halbleitermaterial (4) über dem ersten aktiven Bereich (1), um eine Hauptfläche des ersten aktiven Bereichs (1) freizulegen, wobei der erste aktive Bereich (1) in der Schicht aus dem ersten Halbleitermaterial (2) gebildet wird und der zweite aktive Bereich (3) in der Schicht aus dem zweiten Halbleitermaterial (4) gebildet wird,
- Füllen der Leerbereiche des Substrats und der Ätzmaske (8) mit einem ersten Isoliermaterial (14),
- Glätten des ersten Isoliermaterials (14),
- Ätzen des ersten Isoliermaterials (14), bis die Hauptfläche des ersten aktiven Bereichs (1) freiliegt und der Isolierbereich (5) aus dem ersten Isoliermaterial (14) abgegrenzt ist.

2. Verfahren nach Anspruch 1, **dadurch gekennzeichnet, dass** das Freilegen der Hauptfläche des ersten aktiven Bereichs (1) nach dem Ätzen des ersten Halbleitermaterials (2) durchgeführt wird, um mindestens den ersten aktiven Bereich (1) abzugrenzen.

3. Verfahren nach Anspruch 1, **dadurch gekennzeichnet, dass** es vor dem Ätzen des ersten Halbleitermaterials (2) außerdem im Bereich des Musters des ersten aktiven Bereichs (1) das Ersetzen eines ersten Schutzmaterials (9) der Ätzmaske (8) durch ein zweites Schutzmaterial (12) umfasst, wobei das zweite Schutzmaterial (12) auf ein Ätzverfahren der Isolierschicht (6) reaktiv ist, wobei das Muster des zweiten aktiven Bereichs (3) aus dem ersten Schutzmaterial (9) besteht.

4. Verfahren nach Anspruch 3, **dadurch gekennzeichnet, dass** die Ätzmaske (8) ein erstes Schutzmaterial (9) aufweist, das auf einem zusätzlichen Schutzmaterial (10) aufgebracht ist, in der Ätzmaske (8) im Bereich des Musters, das den Isolierbereich (5) abgrenzt, ein erster Stopfen (11) gebildet wird, wobei das zweite Schutzmaterial (12) nach Entfernung des ersten Schutzmaterials (9) durch das zusätzliche Schutzmaterial (10) gebildet wird.

5. Verfahren nach Anspruch 4, **dadurch gekennzeichnet, dass** es aufeinanderfolgend das Entfernen des ersten Stopfens (11), das Strukturieren des zweiten Halbleitermaterials (4), das Strukturieren der Isolierschicht (6) und das gleichzeitige Entfernen des den ersten aktiven Bereich (1) abgrenzenden zusätzlichen Schutzmaterials (10) und das Strukturieren der Isolierschicht (6) umfasst.

6. Verfahren nach einem der Ansprüche 1 bis 5, **dadurch gekennzeichnet, dass** das Abgrenzen des ersten aktiven Bereichs (1) in der Ätzmaske (8) durch einen Wechsel von Motiven und Leerbereichen erfolgt, wobei der Abstand zwischen zwei Seitenrändern zweier benachbarter Motive kleiner ist als der kleinste Abstand, der zwischen einem Seitenrand eines den ersten aktiven Bereich (1) abgrenzenden Musters und einem Seitenrand eines den zweiten aktiven Bereich (3) abgrenzenden Musters vorhanden ist.

7. Verfahren nach Anspruch 6, **dadurch gekennzeichnet, dass** in den Leerbereichen zwischen den Motiven, die den ersten aktiven Bereich (1) abgrenzen, ein zweiter Pfropfen (13) gebildet wird.

8. Verfahren nach Anspruch 7, **dadurch gekennzeichnet, dass** der zweite Stopfen (13) aus einem Opfermaterial gebildet wird.

9. Verfahren nach einem der Ansprüche 1 bis 8, **dadurch gekennzeichnet, dass** der Isolierbereich (5) einen seitlichen Abstandshalter (15) aufweist, der mindestens die Seitenwand des zweiten aktiven Bereichs (3) überdeckt.

## Claims

1. A method for producing a hybrid substrate comprising:
- providing a substrate successively comprising a support layer (7), a layer made of a first semiconductor material (2), an isolation layer (6) made of a second isolation material and a layer made of a second semiconductor material (4),
- forming an etching mask (8) having distinct patterns respectively delineating an isolation area (5), a first active area (1) and a second active area (3), the first (1) and second (3) active areas being laterally offset and separated by the isolation area (5), the pattern of the isolation area (5) having a polarity opposite the polarity of the patterns of the first active zone (1) and the second active zone (3),
- etching the layers made of the first (2) and second (4) semiconductor materials and the isolation layer (6) to form a void area in the layer made of the first semiconductor material (2) and to delineate at least the isolation area (5) and the first active area (1) in the layer made of the first semiconductor material (2), said etching reproducing in the layers made of first (2) and second (4) semiconductor materials and the isolation layer (6) the patterns originating from the etching mask (8)
- etching the etching mask (8), the isolation layer (6) and the layer made of the second semi-conductor material (4) over the first active area (1) to expose a main surface of the first active area (1), the first active area (1) being formed in the material made of the first semiconductor layer (2) and the second active area (3) being formed in the layer made of the second semiconductor material (4),
- filling the voids of the substrate and the etching mask by the first isolation material (14),
- planarizing the first isolation material (14),
- etching the first isolation material (14) until the main surface of the first active area (1) is released and the isolation area made of first isolation material (14) is delinated.

2. The method according to claim 1, **characterized in that** release of the main surface of the first active area (1) is performed after patterning of the first semiconductor material (2) to delineate at least the first active area (1).

3. The method according to claim 1, **characterized in that** before patterning of the first semiconductor material (2), it comprises replacement of the first protective material (9) of the etching mask (8) by a second protective material (12) in the design of the first active area (1), the second protective material (12) being reactive to an etching process of the isolation layer (6), the design of the second active area (3) being in the first protective material (9).

4. The method according to claim 3, **characterized in that** the etching mask (8) comprising a first protective material (9) deposited on an additional protective material (10), a first plug (11) is formed in the etching mask (8) in the design delineating the isolation area (5), the second protective material (12) being formed by the additional protective material (10) after the first protective material (9) has been eliminated.

5. The method according to claim 4, **characterized in that** it successively comprises elimination of the first plug (11), patterning of the second semi-conductor material (4), patterning of the isolation layer (6) and simultaneous elimination of the additional protective material (10) delineating the first active area (1) and of the patterning of the isolation layer (6).

6. The method according to any one of claims 1 to 5, **characterized in that**, in the etching mask (8), delineation of the first active area (1) being achieved by an alternation of patterns and voids, the distance between two facing side edges of two adjacent patterns is smaller than the smallest distance existing between a side edge of a design delineating the first active area (1) and a side edge of a design delineating the second active area (3).

7. The method according to claim 6, **characterized in that** a second plug (13) is formed in the void areas between the patterns delineating the first active area (1).

8. The method according to claim 7, **characterized in that** the second plug (13) is formed by means of a sacrificial material.

9. The method according to any one of claims 1 to 8, **characterized in that** the isolation area (6) comprises a lateral spacer (15) which covers at least the side wall of the second active area (3).
